(19) Europäisches Patentamt
European Patent Office
Office européen des brevets

(11) **EP 2 030 733 B1**

(12) **EUROPÄISCHE PATENTSCHRIFT**

(45) Veröffentlichungstag und Bekanntmachung des Hinweises auf die Patenterteilung:
**06.10.2010 Patentblatt 2010/40**

(51) Int Cl.:
*B24D 7/02* (2006.01)   *C30B 29/06* (2006.01)
*C30B 33/00* (2006.01)   *B24B 7/22* (2006.01)

(21) Anmeldenummer: **08015053.5**

(22) Anmeldetag: **26.08.2008**

(54) **Verfahren zur Herstellung von Siliziumwafern**

Method for making silicon wafers

Procédé de fabrication de plaquettes de silicium

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **27.08.2007 DE 102007040385**
**27.08.2007 DE 102007040390**

(43) Veröffentlichungstag der Anmeldung:
**04.03.2009 Patentblatt 2009/10**

(73) Patentinhaber: **Schott AG**
**55122 Mainz (DE)**

(72) Erfinder:
• **Menzel, Andreas**
**07745 Jena (DE)**
• **Sigmund, Jochen, Dr.**
**07743 Jena (DE)**
• **Fugger, Chistine, Dr.**
**07743 Jena (DE)**

(74) Vertreter: **Fuchs et al**
**Patentanwälte**
**Naupliastrasse 110**
**81545 München (DE)**

(56) Entgegenhaltungen:
JP-A- 2004 006 997     US-A- 5 484 326
US-A1- 2002 036 182

**Beschreibung**

Die vorliegende Erfindung betrifft ein Verfahren zur Herstellung von Siliziumwafern aus einem Siliziumblock, dessen Seitenflächen vor dem Zerteilen geschliffen werden.

Solch ein Verfahren wird in der US 2002/036182 A gemäß dem Oberbegriff des Anspruchs 1 veröffentlicht.

Siliziumwafer sind dünne Scheiben aus kristallinem Silizium und bilden die Basis für die Herstellung von Solarzellen und daraus folgend für die Herstellung von Solarmodulen. Entsprechend der zunehmenden Verbreitung von Solarzellen und dergleichen nimmt die Nachfrage nach Siliziumwafern von Jahr zu Jahr zu.

Die Produktion der Siliziumwafer beginnt mit der Herstellung von Blöcken aus kristallinen Siliziumingots, und zwar sowohl aus mono- als auch aus polykristallinem Material, die in runder Form oder auch als Quader gezüchtet werden. In einem weiteren Schritt werden dann diese kristallinen Ingots zu weiteren quaderförmigen Blöcken zerteilt bzw. gesägt. Diese Blöcke werden auch als Säulen oder Bricks bezeichnet und weisen üblicherweise bei monokristallinem Silizium einen annähernd quadratischen bzw. bei multikristallinem Silizium einen exakt quadratischen Querschnitt auf. Aus diesen Blöcken werden dann in einem weiteren Schritt die einzelnen Waferscheiben herausgesägt, und zwar üblicherweise quer zu ihrer Längsrichtung, so dass die durch Sägen entstandenen Seitenflächen der säulenförmigen Blöcke bzw. Bricks die Kantenflächen der so erzeugten Wafer bilden. Es hat sich gezeigt, dass bei der Herstellung der Bricks an den durch Sägen entstandenen Seitenflächen feinste, oft mikroskopisch kleine Risse entstehen, die mit einer mehr oder weniger großen Eindringtiefe in das Volumen des Blockes bzw. damit in die Kanten des späteren Wafers vordringen.

Silizium ist ein äußerst sprödes Material. Anders als bei Metallen kann sich ein Riss im Material daher bei Belastung rasch ausbreiten. Eine normale Beanspruchung, beispielsweise beim Handling in der Zellenproduktion, kann bei Vorhandensein von Rissen, insbesonders in der Kante des Wafers, schnell zum Bruch des Wafers führen.

Da die Herstellung der Siliziumwafer einen Kostenanteil von ca. 55% an der Herstellung der Solarzellen ausmacht, führt ein hoher Anteil an zerbrochenen Siliziumwafern, d. h. eine hohe Bruchrate, zu einem deutlichen Kostenanstieg in der Herstellung der Solarzellen.

Darüber hinaus gebietet es die weltweite Verknappung von Silizium, in der Zukunft extrem dünne Siliziumwafer herzustellen. Sofern Risse in diesen dünnen Siliziumwafern vorliegen, neigen diese dünnen Wafer verstärkt zu einem Bruch. Risse in den Kanten der Wafer sind besonders kritisch.

Zur Vermeidung der zuvor beschriebenen Probleme wird deshalb in der US 2002 036182 AA vorgeschlagen, die Rauhigkeit der Oberflächen solcher Siliziumblöcke vor der Herstellung der Siliziumwafer zu verringern, was gemäß der JP 3,648,239 mittels einem mechanischen Polieren erfolgen soll. Dabei wird im besten beschriebenen Fall (Example 6) lediglich eine Rauhigkeit Ry von kleiner 1 μm erreicht. Dies reicht für die Herstellung von Wafern, insbesonders solchen mit einer Dicke kleiner oder gleich 180 μm bei weitem nicht aus. Weiterhin sind die beschriebenen Verfahrensvarianten "Bearbeitung mit losem Korn" (Method 1 und sponge whell), Bearbeitung mit Bürsten mit und ohne anhaftender Abrasivkörner an den Bürstenhaaren und Bearbeitung mit in ein sponge wheel eingebetteten Abrasivkörnern gänzlich nicht geeignet, definierte, richtungsunkritische Bearbeitungsspuren in deutlich verbesserter Oberflächenrauhigkeit auf den Seitenflächen der Si-Bricks zu hinterlassen. Schließlich wird in der US-A 5,484,326 ein Zerteilungsverfahren für einen Halbleiter beschrieben, bei dem die Oberflächen eines Siliziumblocks zuvor geschliffen werden.

Es hat sich jedoch gezeigt, dass mit diesen Verfahren zwar eine Verbesserung der Bruchhäufigkeit der geschnittenen Siliziumwafer erreicht werden kann, dies jedoch insbesondere für sehr dünne Wafer nicht ausreichend ist.

Eine Aufgabe der vorliegenden Erfindung war es daher, die Bruchrate bei der Herstellung von Siliziumwafern zu verbessern und deutlich zu reduzieren. Insbesondere soll die Bruchrate bei der Produktion von möglichst dünnen Wafern mit einer Dicke von kleiner oder gleich 180 μm reduziert werden. Diese Reduzierung soll außerdem mit einer Technologie erreicht werden, die auf den für das mechanische Polieren typischerweise sehr geringen Materialabtrag pro Zeiteinheit verzichtet.

Diese Aufgabe wird durch ein Verfahren zur Herstellung von Siliziumwafern gemäß Anspruch 1 gelöst. Es hat sich nämlich überraschenderweise gezeigt, dass sich die Bruchrate von Siliziumwafern ganz besonders verringern lässt, wenn die Seitenflächen eines Siliziumblocks bzw. -bricks derart geschliffen oder poliert werden, dass die Schleif- oder Polierrichtung im Wesentlichen parallel zur späteren Schnittebene, in der die Wafer aus dem Siliziumblock geschnitten bzw. gesägt werden, verläuft. Dadurch verläuft die Schleif-/Polierrichtung entlang der Außenkante der späteren Waferscheibe.

Im Sinne der vorliegenden Erfindung bedeutet Schleifen eine abrasive mechanische Oberflächenbehandlung, bei der die Schleifkörper bzw. Schleif- oder Schneidekörner nicht lose, sondern gebunden, beispielsweise in einer Matrix vorliegen. Erfindungsgemäß erfolgt die jeweilige Bewegung des Schleif- bzw. Schneidpartikels oder Kornes im Wesentlichen parallel zur späteren Schnittebene und verläuft somit entlang der Kantenfläche der späteren Waferscheibe. Polieren im Sinne der vorliegenden Erfindung bedeutet ebenfalls einen Materialabtrag mit gebundenem Korn, der im duktilen Bereich stattfindet. Dabei bedeutet ein Materialabtrag im duktilen Bereich, dass sich das Material beim Abtragen plastisch verformt, wobei keine Stress- und Spannungsschäden in die behandelte Oberfläche eingetragen werden. Dieser duktile Materialabtrag ist gegeben, wenn durch die Schleifparameter gesichert wird, dass die Eingriffstiefe des einzelnen Schleifkornes kleiner als 40 bzw. kleiner 30 nm ist. Der Begriff Polieren wird für eine derartige mittels Schleifen erzielte Oberflächenqualität deshalb benutzt, weil das für polierte Oberflächen übliche Qualitätskriterium, dass die maximale Rauhtiefe $R_t$ (Rautiefe) unterhalb der Lichtwellenlänge ($\lambda/2$ bis $\lambda/60$) liegt, erfüllt ist.

Erfindungsgemäß wird unter Schleifen bzw. Polieren eine abrasive mechanische Oberflächenbehandlung verstanden. Je nach dem, ob der Materialabtrag im Sprödbruchbereich, im Übergangsbereich oder im duktilen Bereich erfolgt, entstehen in der Oberfläche nahezu keine Risse oder mehr oder weniger tief reichende Risse. Ein Materialabtrag im duktilen Bereich verursacht nur theoretisch keine Risse. Praktisch können Schleifkörner aus ihrer Matrix ausbrechen und durch unkontrollierte Bewegungen doch kleine Risse erzeugen.

Die auftretenden Risse sind bei einer Rauhigkeitsmessung (z. B. durch optische oder mechanische Profilometer, Atomic Force Microscope, der Oberfläche nur teilweise detektierbar. Den Teil eines Risses, der unterhalb der Oberfläche liegt, erfassen die genannten Verfahren nicht. Derartige unterhalb der Oberfläche liegende Defekte, insbesonders Risse, sind jedoch für ein späteres Reißen und Bersten des Materials (z. B. des Wafers) verantwortlich.

In der vorliegenden Erfindung entsprechen die Seitenflächen des Siliziumblocks bzw. -bricks nach dem Schneiden des Blocks den Umfangflächen, d. h. den Kanten des Wafers.

Es wurde gefunden, dass nicht die Rauhigkeit der Seitenflächen des Siliziumblocks die Hauptursache des Waferbruchs ist. Vielmehr sind feinste, mikroskopisch kleine Risse sowie unter der Oberfläche in den oberflächennahen Schichten vorliegende Defekte, sog. Subsurface-Defekte, wie beispielsweise Mikrorisse für den Bruch ausgehend von der Waferkante verantwortlich. Gerade solche oberflächennahen Defekte werden durch die Bearbeitung im Sprödbrüche verursachenden Belastungsfall gebildet. Dabei hat es sich gezeigt, dass insbesondere die Tiefe und der Verlauf der Mikrorisse entscheidend für das Bruchverhalten der Siliziumwafer ist. Risse, die senkrecht zur Schnittebene, d. h. senkrecht zur Seitenfläche des Siliziumbricks bzw. -blocks verlaufen, d. h. in Richtung der späteren Waferoberfläche, sind besonders kritisch für den Bruch der Siliziumwafer. Dagegen beeinflussen Risse die parallel zur Schnittebene, d. h. parallel zur, d. h. entlang der späteren Waferkante verlaufen, den Bruch der Siliziumwafer kaum.

Erfindungsgemäß wurde daher gefunden, dass sich die Anzahl der kritischen bzw. weniger kritischen Risse, die einen späteren Bruch des Siliziumwafers hervorrufen, durch die Art der Oberflächenbehandlung stark beeinflussbar ist. Es hat sich nämlich gezeigt, dass mittels der Vorgehensweise des bekannten Standes der Technik, bei dem lediglich die Oberflächenrauhigkeit durch einen Schleifprozess verringert wird, neue kritische Defekte erzeugt werden, und zwar durch Bearbeitungsspuren, die mehr oder weniger senkrecht zur Längsausdehnung der späteren Waferkante verlaufen. Gerade diese werden mittels der vorliegenden Erfindung durch die Bearbeitungsrichtung gedreht, so dass von den auch bei erfindungsgemäß erfolgter Bearbeitung noch vorhandenen Bearbeitungsspuren keine Bruchgefahr ausgeht. Es hat sich nämlich gezeigt, dass Risse, die parallel zur späteren Schnittebene, d. h. parallel zur späteren Waferkante verlaufen, den Bruch des Wafers kaum beeinflussen. Im Rahmen der Erfindung wurde gefunden, dass sich auf diese Weise erreichen lässt, dass die zum Waferbruch führenden Risse nicht mehr von der tiefsten Stelle solcher Bearbeitungsspuren ausgehen können, sondern nur noch vom unvermeidbar entstehenden surface damage.

Durch das erfindungsgemäße Verfahren wird erreicht, dass Bearbeitungsriefen, verursacht durch die sich bewegenden Schleifkörper, im Wesentlichen parallel zur Waferkante verlaufen. Wird ein gesägter Wafer im nachfolgenden Handlingsprozess durchgebogen, so werden von der tiefsten Stelle einer solchen Bearbeitungsriefe keine Risse ausgehen. Bei einer Blockbearbeitung nach dem Stand der Technik (Richtung der Bearbeitungsriefen ist um 90° gedreht) werden beim Biegen der Wafer jedoch Risse von der tiefsten Stelle der Bearbeitungsriefe ausgehen und zum Bruch des Wafers führen.

In einer bevorzugten Ausführungsform wird der Siliziumblock bzw. Brick mittels einem Werkzeug geschliffen bzw. poliert, welches eine zylinderförmige Form aufweist. In einer bevorzugten Ausführungsform weist das Werkzeug die Form eines Hohlzylinders auf, so dass die Endflächen des Mantels des Hohlzylinders die Schleif- bzw. Polierflächen darstellen. Derartige Werkzeuge werden üblicherweise auch als sog. Topfschleifer bezeichnet.

Bevorzugt weist das zylinderförmige Werkzeug einen Durchmesser von wenigstens dem 1,5-fachen, besonders bevorzugt von wenigstens dem 1,55-fachen, ganz besonders bevorzugt von wenigstens dem 1,75-fachen der zu behandelnden Flächenbreite des Siliziumbricks auf.

Solche Schleifwerkzeuge, die einen Topfschleifer umfassen sind beispielsweise von der Firma Saint-Gobain Diamantwerkzeuge GmbH & Co KG in Norderstedt, Deutschland, von der Firma Wendt GmbH in Meerbusch, Deutschland, von der Firma Günter Effgen GmbH in Herstein, Deutschland oder von der Firma Herbert Arnold GmbH & Co KG in Weilburg, Deutschland erhältlich.

Die Dicke des Hohlzylindermantels des Schleifwerkzeuges bzw. Topfschleifers beträgt üblicherweise mindestens 3 mm. Maximal sinnvolle Dicken betragen üblicherweise 2 bis 3 cm, wobei Dicken von 1 cm bis 2 cm bevorzugt sind. Ganz besonders bevorzugt sind Dik-

ken von 12 bis 17 mm.

In einer bevorzugten Ausführungsform umfasst das Schleifwerkzeug eine Matrix, in der die Partikel des Schleifkörpers eingebettet bzw. mehr oder weniger fest gebunden sind.

Zweckmäßigerweise weisen die Schleifkörner eine Härte auf, die deutlich größer ist als diejenige des kristallinen Siliziums.

Vorzugsweise bestehen die Schleifkörner aus Diamant, wobei sich Schleif- oder Schneidkörner aus Siliziumcarbid und/oder Siliziumnitrid sich ebenfalls als geeignet erwiesen haben.

Vorzugsweise wird eine Matrix aus einem Material verwendet, das ausgewählt ist aus der Gruppe bestehend aus einem weichen Metall wie z. B. Bronze, wenigstens einem Polymer und wenigstens einem Harz.

Werden Schleifkörner während des Bearbeitungsprozesses aus ihrer Matrixbindung herausgerissen, dann tritt ebenfalls ein schneller, beschleunigter Abtrag des weichen Matrixmaterials auf, so dass neue Schleifkörner zum Vorschein kommen. Dieser Prozess wird auch als sog. Selbstschärfen bezeichnet, so dass das Werkzeug erst, wenn die Schleifkörner abgetragen, d. h. verbraucht sind, ersetzt werden muss.

In einer erfindungsgemäß bevorzugten Ausführungsform werden Schleifkörner mit größeren Teilchendurchmesser, d. h. solche Partikel, mit denen ein gröberes Vorschleifen erfolgt, in eine Matrix aus Bronze eingebettet bzw. gebunden, wohingegen die für ein Feinoder Nachschleifen verwendeten Partikel in eine Kunststoffmatrix eingebettet bzw. eingebunden werden.

Vorzugsweise weisen die Schleifkörner im Mittel einen Durchmesser im Bereich zwischen 3 $\mu$m und 160 $\mu$m auf. Je nach dem, ob der Block bzw. Brick nun auf eine genaue Dimension geschliffen oder besonders glatt und schädigungsarm geschliffen bzw. eine Oberfläche mit Polierqualität erreichen soll, werden verschiedene Werkzeuge mit verschieden großen bzw. harten Schleif- bzw. Polierpartikeln verwendet. So wird beispielsweise für den Fall, dass die Dimension eines Blokkes eingestellt werden soll, üblicherweise ein Topfschleifwerkzeug mit Schleif- oder Schneidkörnern bzw. Partikeln eingesetzt, die einen mittleren Durchmesser von mindestens 80 und höchstens 160 $\mu$m aufweisen. Besonders bevorzugt sind hierzu Partikel mit einem mittleren Durchmesser von mindestens 85 bzw. maximal 130 $\mu$m. Sollte jedoch eine besonders schädigungsarme Oberfläche erzeugt werden, wie dies beispielsweise in einem weiteren zweiten Schleif- bzw. Polierqualität erreichenden Prozess in einer bevorzugten erfindungsgemäßen Ausführungsform durchgeführt wird, dann werden üblicherweise mittlere Schleifkorndurchmesser von mindestens 3, insbesondere mindestens 10 $\mu$m verwendet, wobei sich eine maximale Größe von maximal 40 $\mu$m, bevorzugt maximal 25 $\mu$m als geeignet erwiesen hat. In einer bevorzugten erfindungsgemäßen Ausführungsform wird zuerst der Siliziumblock oder -brick mit einem grobkörnigen Schleifwerkzeug behandelt und anschließend mit einem feinkörnigen Schleifwerkzeug.

Weist das Schleifwerkzeug Schleifkörner mit einem mittleren Durchmesser im Bereich von 80 bis 160 $\mu$m auf, wird es als grobkörniges Schleifwerkzeug bezeichnet, so dass ein Schleif- oder Polierverfahren, bei dem entsprechend grobkörnige Schleifkörner bzw. Partikel verwendet werden, auch als Grobschleifen bezeichnet wird.

Weist das Schleifwerkzeug Schleifkörner mit einem mittleren Durchmesser im Bereich von 3 bis 40 $\mu$m auf, wird es als ein feinkörniges Schleifwerkzeug bezeichnet. Ein entsprechender Prozess, in dem feinkörnige Schleifkörner bzw. Partikel eingesetzt werden, wird dementsprechend auch als Feinschleifen bezeichnet.

Ein entsprechender Prozess, in dem ein Schleifwerkzeug mit feinkörnigen Schleifkörnern zum Einsatz kommt, kann Oberflächenqualitäten erzielen, die denen für polierte Oberflächen entsprechen. Wenn durch die Prozessparameter gesichert wird, dass die Eingriffstiefe des einzelnen Schleifkornes von kleiner 40 nm eingestellt wird und damit ein Abtrag in duktilen Bereich erfolgt, wird erreicht, dass die maximale Rautiefe $R_t$ unterhalb der Lichtwellenlänge, d. h. im Bereich kleiner $\lambda/2$, liegt. Die erzielte Oberfläche gilt im Sinne der vorliegenden Erfindung dann als poliert. Es sei an dieser Stelle klargestellt, dass als Abrasivkörner für ein Polieren mit losem Korn zur Erreichung einer Oberflächenqualität mit einer Rautiefe $R_t$ im Bereich kleiner $\lambda/2$ solche mit einem Durchmesser von generell kleiner/gleich 1 $\mu$m verwendet werden, wohingegen im erfindungsgemäßen Verfahren zur Erreichung feingeschliffener, durch spröden Materialabtrag, duktilen Materialabtrag bzw. im Grenzbereich beider Materialabtragungsmechanismen liegenden Materialabtrag Abrasivkörner mit einem Durchmesser größer/gleich 3 $\mu$m verwendet werden. Dabei erfolgt ein duktiler Abtrag unter Bedingungen, die einen plastisch verformbaren Materialabtrag erlauben, ohne dass das darunter liegende Material beschädigt wird, wie dies bei einem spröden Abtrag der Fall ist. Üblicherweise wird dies durch ein schnelles Schleifen bei hoher Geschwindigkeit erreicht, wodurch eine lokale Erwärmung des abzutragenden Materials erfolgt, so dass das Abrasivkorn das plastische Material spanend abträgt bzw. abschabt.

Vorzugsweise wird für grobkörnige Schleifwerkzeuge eine Matrix aus einem weichen Metall, wie beispielsweise Bronze, verwendet. Für feinkörnige Schleifwerkzeuge wird dagegen üblicherweise ein Polymer oder ein Kunstharz als Matrix verwendet. Als Maß der Konzentration der Schneidkörner in einer Kunststoffmatrix bzw. Kunstharzmatrix wird erfindungsgemäß eine Konzentration eingesetzt, welche unter der Bezeichnung Kunststoffbindung im Bereich C60 bis C85 erhältlich ist. Vorzugsweise wird eine Konzentration von C75 eingesetzt.

Vorzugsweise wird dem Topfschleifer im vorstehend genannten Prozess eine Schnittgeschwindigkeit von ungefähr 20 bis 50 m/s eingestellt. Entsprechend des Zusammenhanges

$$V_s = \Pi * D * n$$

$V_s$ = Schnittgeschwindigkeit
$\Pi$ = 3,1416
D = Durchmesser des Schneidwerkzeuges (Topfschleifer)
N = Drehzahl

können für D und n geeignete Werte gewählt werden, um die gewünschte Schnittgeschwindigkeit einzustellen. Eine vergleichbare Geschwindigkeit kann auch für das erfindungsgemäß definierte Polieren verwendet werden. Der Topfschleifer kann dabei einen wesentlich größeren Durchmesser haben als die Breite der zu schleifenden Siliziumblöcke. Auf diese Weise ist es möglich für die Bearbeitung von Siliziumblökken verschiedener Breite, beispielsweise für die Bearbeitung von von 5-inch, 6-inch oder 8-inch Siliziumblöcken, Topfschleifer mit einem Durchmesser von 200 mm oder größer einzusetzen, um damit die gesamte Breite des Siliziumblocks bei jedem Bearbeitungsschritt zu überdecken. Ein spanender und möglichst schonender Materialabtrag am Siliziumblock, insbesondere mittels eines Schleifwerkzeuges, erfolgt mit einem erfindungsgemäß großen Durchmesser, z. B. von 200 bis 350 mm und großer Drehzahl (Rotation) im Bereich von üblicherweise mindestens 1500, wobei mindestens 1800 bzw. 2000 Umdrehungen pro Minute bevorzugt ist. Typische zweckmäßige maximale Drehzahlen betragen insbesondere maximal 6000 Umdrehungen, üblicherweise maximal 5000 Umdrehungen, wobei maximal 4000 Umdrehungen bevorzugt sind. Besonders bevorzugt sind maximale Umdrehungen von 3500, insbesondere 3100 Umdrehungen pro Minute, wobei Rotationsgeschwindigkeiten von maximal 3000 ganz besonders bevorzugt sind. Die erfindungsgemäße Verwendung eines großen Topfschleifers stellt damit einen schnellen Materialabtrag bei einer gleichzeitig geringen Oberflächenschädigung sicher.

Vorteilhafterweise ist der Siliziumblock im erfindungsgemäßen Verfahren im Wesentlichen rechteckig. Allerdings besteht für die Form des Siliziumblocks keine Einschränkung, so dass das erfindungsgemäße Verfahren auch mit Siliziumblöcken, die eine andere Form aufweisen durchgeführt werden kann. Vorteilhafterweise weist der Siliziumblock eine quadratische Querschnitts- bzw. Grundfläche im Bereich zwischen 220 x 220 mm² und 100 x 100 mm², bevorzugt im Bereich zwischen 125 x 125 mm² (5 Zoll), 156 x 156 mm² (6 Zoll) und 210 x 210 mm² (8 Zoll) auf. Übliche Höhen bzw. Längen betragen mindestens 150 mm, insbesondere maximal 600 mm, insbesondere maximal 500, vorzugsweise minimal 200 und maximal 450 mm.

Von den Seitenflächen des Siliziumblocks bzw. -bricks wird jeweils eine Dicke von mindestens 20 $\mu$m abgeschliffen, wobei insbesondere mindestens 25 bzw. 30 $\mu$m bevorzugt sind. Als extrem geeignet haben sich Abschliffdicken von mindestens 50 $\mu$m, insbesonders mindestens 130 bzw. 150 $\mu$m gezeigt, wobei mindestens 180 $\mu$m besonders bevorzugt ist. Aus ökonomischen Gründen haben sich maximale Abschliffdicken von maximal 500 $\mu$m, insbesonders maximal 400 $\mu$m als geeignet erwiesen, wobei maximal 300 $\mu$m bevorzugt sind. Ganz besonders bevorzugt sind Abschliffdicken von maximal 280 bzw. maximal 250 $\mu$m.

Ein weiterer Gegenstand der vorliegenden Erfindung ist ein Verfahren zur Herstellung von insbesonders dünnen Siliziumwafern durch Zerteilen eines Siliziumblocks bzw. -bricks, wobei

die Seitenflächen des Siliziumblocks bzw. -bricks im Sinne der vorliegenden Erfindung im Wesentlichen parallel zur Außenfläche der späteren Waferkante (Querschnittskante des Bricks bzw. Schnittebene) des Siliziumblocks geschliffen und/oder poliert werden

und danach der Siliziumblock parallel zur Querschnittsfläche des Bricks (Schnittebene) bzw. senkrecht zu seiner Längsachse in Scheiben geschnitten wird.

Vorzugsweise werden die Seitenflächen des Siliziumbricks im Wesentlichen parallel zur späteren Schnittebene in zwei Schritten geschliffen oder poliert. Dabei wird in einem ersten Schritt ein Schleifwerkzeug mit Schleifkörnern eines Durchmessers im Mittel von größer 70 $\mu$m, vorzugsweise größer 80 $\mu$m, insbesonders größer 90 $\mu$m verwendet. In einer weiteren abrasiven Behandlung wird ein Schleifwerkzeug mit Schleifkörnern eines Durchmessers im Mittel von vorzugsweise kleiner 30 $\mu$m, insbesondere von kleiner 20 $\mu$m, ganz besonders bevorzugt von kleiner 15 $\mu$m verwendet. Dieser zweite Bearbeitungsschritt kann durch die Wahl einer geringen Zustellung bzw. eines geringen Vorschubs so geführt werden, dass die Eingriffstiefe des einzelnen Schleifkornes 40 nm, insbesondere 30 nm nicht übersteigt. Dadurch erfolgt der Materialabtrag im duktilen Bereich und es wird eine Oberflächenqualität erreicht, die dem Qualitätskriterium für polierte Oberflächen entspricht. Das Schleifen des Siliziumblocks in zwei Schritten kann dabei durch die Verwendung von Topfschleifern mit Schleifkörnern von unterschiedlichem Durchmesser erfolgen. Ist nur ein Grobschliff erwünscht, wird das Werkzeug mehrmals bis zum Erreichen des erforderlichen Abtrags über die Oberfläche geführt. Ist ein Feinschliff erwünscht, wird das Werkzeug zusätzlich nur einmal über die Oberfläche geführt. Soll eine nahezu störungsfreie duktil bearbeitete Oberfläche erzielt werden, ist ein Freischleifen der Oberfläche (ohne Zustellung ein zusätzliches Mal mit dem Werkzeug über die Oberflächen fahren) vorzunehmen. Dieser zusätzliche Schritt erfordert eine exakte Werkzeuglagerung und -färbung (aerostatische bzw. hydrostatische Werkzeugspindellagerung und hydrostatische Führung). Dem Fachmann ist bekannt, dass die Zustellung je Überstreichen der Bearbeitungsflächen mit dem Werkzeug die Oberflächenqualität ebenfalls beeinflussen. Durch Austesten von Werten der Zustellung im Bereich von 1 $\mu$m bis 100 $\mu$m bzw. des Vorschubs zwischen 10 mm/min und 1000 mm/min kann ein Prozesszeit und Oberflächenqualität optimiertes Vorgehen ermittelt werden.

Ein weiterer Gegenstand der vorliegenden Erfindung ist daher ein Verfahren zur Herstellung von Siliziumwafern, wobei die Seitenflächen des Siliziumblocks in einem Schritt a1)

mit einem grobkörnigen, hohlzylinderförmigen Werkzeug (Topfschleifer) geschliffen werden. Vorzugsweise enthält das Werkzeug Schneid- bzw. Schleifkörner mit einem Durchmesser im Mittel von größer 80 $\mu$m, insbesonders größer 90 $\mu$m und höchstens 160 $\mu$m und

in einem Schritt a2)

mit einem feinkörnigen hohlzylinderförmigen Werkzeug geschliffen oder poliert wird, das Schleif- bzw. Schneidkörner mit einem Durchmesser im Mittel von kleiner 30 $\mu$m, bevorzugt von kleiner 20 $\mu$m, ganz besonders bevorzugt von kleiner 15 $\mu$m aufweist und üblicherweise einen Mindestdurchmesser von 3 $\mu$m hat

und in einem Schritt c)

der Siliziumblock wie zuvor beschrieben geschnitten bzw. zersägt wird.

Erfolgt nach einem Grobschliff ein Feinschliff, dann hat es sich als besonders zweckmäßig erwiesen, dass das Abtragsverhältnis von Grobschliff zu Feinschliff mindestens 5:1, vorzugsweise mindestens 8:1 bzw. 9:1 beträgt. Maximal beträgt das Verhältnis Grobschliff zu Feinschliff 12:1, wobei 10:1 bevorzugt ist.

Unter einem Mikroriss wird im Rahmen der Erfindung ein durch mechanische Beschädigung des Materials entstandener Trennungsspalt verstanden, in dem sich Teile eines zuvor einheitlichen Volumens berühren. Ein Riss weist in seinem Querschnitt meist eine scharfe Spitze auf.

Wird ein hohlzylinderförmiges Schneid- oder Polierwerkzeug verwendet, welches um seine Hohlzylinderachse rotiert, dann ist die Rotationsachse in einer erfindungsgemäß ganz besonders bevorzugten Form gegenüber der zu schleifenden Oberflächennormale, d. h. gegenüber der senkrecht zu behandelnden Oberfläche rechtwinklig stehenden Normale leicht gekippt, und zwar vorzugsweise in Richtung der Längsachse des Bricks. Dabei kann die Verkippung der Rotationsachse nach vorne oder nach hinten erfolgen. Typische maximale Verkippungsgrade betragen üblicherweise 0,1 bzw. 0,07 Winkelgrade, wobei Winkelgrade von maximal 0,05, insbesonders 0,04 bevorzugt sind. Minimale Verkippungswinkel betragen üblicherweise 0,001, insbesonders 0,003 Winkelgrade, wobei minimale Verkippungswinkel von 0,005, insbesonders 0,008 bevorzugt sind. Erfindungsgemäß wurde nämlich auch gefunden, dass durch ein Verkippen des Rotationswinkels die besonders empfindlichen Längskanten der Bricks einem geringeren Stress unterworfen werden, da dort der über das Werkzeug ausgeübte Schleif- und Polierdruck herabgesetzt ist. Außerdem wird durch die Schrägstellung (Kippung) verhindert, dass die der im Materialeingriff befindlichen Seite des Werkzeugs um 180° gegenüberliegende Seite des Werkzeugs die zu bearbeitende Fläche berührt. Ein Schwingen und damit einhergehende undefinierte Materialeingriffszustände werden so vermieden.

In einer erfindungsgemäß besonders bevorzugten Ausführungsform wird der Siliziumblock bzw. Siliziumbrick nach dem zuvor beschriebenen Schleifen bzw. Polieren der Seitenflächen und vor dem Zerschneiden bzw. Zersägen zu Siliziumwafern einem isotropen Ätzen unterworfen, wie dies in der zeitgleich eingereichten parallelen Anmeldung (DE 10 2007 040 390 A) beschrieben ist.

Im Sinne der vorliegenden Erfindung wird unter Ätzen das chemische Abtragen bzw. Auflösen von Material, d. h. von Siliziummaterial, verstanden, und zwar auch in den Vertiefungen bzw. Rissen, welche an oder auch unter der Oberfläche vorliegen. Unter dem Begriff "isotropes Ätzen" wird demgemäß erfindungsgemäß ein chemischer Abtrag verstanden, der entlang jeder Kristallrichtung mit mehr oder weniger gleichmäßiger Geschwindigkeit erfolgt, d. h. dass die Ätzgeschwindigkeit entlang der <100>-Ebene, der <111>-Ebene sowie der <110>-Ebene im Wesentlichen gleichförmig verläuft. Dabei wird erfindungsgemäß ein Ätzen als isotrop bezeichnet, dessen Ätzgeschwindigkeit in verschiedenen Kristallrichtungen im Wesentlichen gleichförmig ist und sich vorzugsweise nicht mehr als das 3-, insbesonders nicht mehr als das 2-fache voneinander unterscheidet.

Darüber hinaus wird erfindungsgemäß derart geätzt, dass der Abtrag über die jeweilige Oberfläche des Siliziumbricks hinweg mehr oder weniger gleichmäßig erfolgt. Ein im Wesentlichen gleichmäßiger Abtrag bedeutet im Rahmen der vorliegenden Erfindung, dass die Höhe des Abtrags über die gesamte jeweilige Seitenfläche maximal um 10 $\mu$m schwankt, wobei maximale Schwankungen von 8, insbesonders von 5 bzw. 4 $\mu$m besonders bevorzugt sind.

Im erfindungsgemäßen Verfahren erfolgt das Ätzen üblicherweise mit einer mittleren Abtragsgeschwindigkeit von 1 bis 20 $\mu$m pro Minute, insbesonders von 3 bis 15 $\mu$m pro Minute.

Auf diese Weise wird vermieden, dass sich Risse am gesägten Wafer von der Waferkante ausgehend in Richtung des Inneren des Wafers fortsetzen. Somit kann auch die Bruchrate der Siliziumwafer deutlich gesenkt werden.

Vorzugsweise wird der Siliziumblock für eine Dauer von mindestens 30s, vorzugsweise mindestens 45s, insbesonders mindestens 60 Sekunden geätzt. Eine typische maximale Behandlungsdauer beträgt 300 Sekunden, wobei maximal 250s, insbesonders maximal 200s bzw. 150 Sekunden bevorzugt sind. Dabei hängt die Dauer auch von der Größe der Oberfläche, der Temperatur und der Ätzrezeptur ab und wird jeweils so gewählt, dass ein isotropes Ätzen bzw. ein Ätzen im Grenzbereich isotrop/ anisotrop möglich ist. Die jeweiligen Bedingungen für ein Ätzen im isotropen Bereich bzw. Grenzbereich isotrop/ an- isotrop sind vom Fachmann anhand weniger Versuche zu ermitteln.

Die im Mittel abzutragende Schichtdicke ist vom Ausgangszustand der Mantelfächen des Bricks vor Ätzbeginn abhängig. Ist die Mantelfläche des Bricks roh gesägt, d. h. Ergebnis eines Drahtsägeprozesses (Squaren), dann ist ein mittlerer Abtrag von 25 bis 100 μm erforderlich. Ist die Mantelfläche des Bricks nach dem Squaren noch grob geschliffen worden (Dimensionsschleifen), dann sind im Mittel 8 bis 50 μm abzuätzen. Ist die Mantelfläche des Bricks zusätzlich noch feingeschliffen worden, sind im Mittel nur 5 bis 25 μm abzuätzen. Ist die Mantelfläche des Bricks jedoch vollständig im duktilen Bereich feingeschliffen worden mit dem Ergebnis, dass die Oberfläche dem Kriterium für polierte Oberflächen entspricht, d. h. die maximale Rautiefe $R_t$ liegt mit λ/2 bis λ/60 unterhalb der Lichtwellenlänge, kann ein Ätzen unterbleiben. Da auch eine solche Oberfläche infolge beim Feinschleifen ausbrechender Schleifkörner nicht 100%-ig frei von Subsurface-Defekten ist, kann durch sehr kurzzeitiges Ätzen von 20 bis 30 Sekunden immer noch eine geringfügige Verbesserung der Bruchgefahr des Wafers erreicht werden.

Vorzugsweise wird der Siliziumblock bei einer möglichst geringen Temperatur geätzt, wobei jedoch aus ökonomischen Gründen sich Temperaturen von mindestens 18°C, insbesonders mindestens 20°C als zweckmäßig erwiesen haben. Weitere zweckmäßige Maximaltemperaturen betragen höchstens 25, insbesonders höchstens 23°C, wobei Höchsttemperaturen von 22°C besonders bevorzugt sind.

Erfindungsgemäß wurde auch gefunden, dass ein isotropes Verhalten dadurch gesteigert werden kann, dass die jeweils gewählte Temperatur während der Ätzdauer sowie an den unterschiedlichen Ätzstellen, d. h. an verschiedenen Stellen des Siliziumbricks maximal +/- 2°C schwankt, wobei maximale Unterschiede von +/- 1°C, insbesonders +/- 0,5°C bevorzugt sind. Ganz bevorzugt sind Schwankungen, die nicht größer als +/- 0,2 bzw. +/- 0,1°C betragen. Eine große Flüssigkeitsmenge und hohe Kühlleistung erleichtert das Einhalten dieser Bedingungen. Das Einhalten einer möglichst konstanten Temperatur fördert dabei das isotrope Verhalten beim Ätzen.

Bei dem verwendeten Ätzverfahren handelt es sich um ein Nass-Ätzverfahren, das vorzugsweise in einem sauren Medium durchgeführt wird. Bevorzugte Säuren sind starke oxidierende Säuren wie Schwefelsäure, Salpetersäure und/oder Flusssäure, sowie die entsprechenden Peroxosäuren hiervon.

Vorzugsweise wird der Siliziumblock mit einer Lösung von 50-70%-iger Salpetersäure und 40-60%-iger Flusssäure in einem Verhältnis im Bereich von 10:1 bis 1:1, bevorzugt im Bereich von 8:1 bis 4:1 geätzt, wobei die vorgenannten Verhältnisse Volumenverhältnisse sind.

Dieser Mischung werden üblicherweise noch weitere Additive zugesetzt, die das Ziel haben, die Reaktion zu moderieren. Bevorzugt wird der Lösung eine Flüssigkeit, wie z. B. Wasser, Essigsäure, Wasserstoffperoxid oder ein die Oberflächenenergie senkendes Tensid (Netzmittel), zugesetzt.

Unter dem Begriff Oberflächenrauhigkeit wird im Rahmen der Erfindung die Unebenheit der Oberflächenhöhe verstanden.

Vorzugsweise beträgt das Verhältnis der Oberflächenrauhigkeit $R_{max}$ der jeweils erfindungsgemäß behandelten Seitenfläche nach dem Ätzen zur Oberflächenrauhigkeit $R_{max}$ der Seitenfläche vor dem Ätzprozess 10:1 bis 0,5:1, üblicherweise von 8:1 bis 0,5:1, ganz besonders bevorzugt in einem Bereich von 7:1 bis 1:1.

Es wurde ebenfalls erfindungsgemäß gefunden, dass auch eine Vergrößerung der Oberflächenrauhigkeit keine nachteiligen Brucheigenschaften hervorruft, insbesondere dann, wenn eine feingeschliffene Ausgangsoberfläche vorliegt. Die durch Unebenheiten in der Oberfläche durch Ätzen bewirkte Oberflächenrauhigkeit darf erfindungsgemäß und wie bereits zuvor gesagt sehr hoch sein, solange die Breite der jeweiligen Wellentäler bzw. Rauhigkeitstäler groß ist sowie deren tiefsten Punkte abgerundet sind.

Erfindungsgemäß kann daher ohne weiteres auch bis in große Ätztiefen wie beispielsweise bis 100 bzw. 80 μm ein Materialabtrag erfolgen, wobei jedoch üblicherweise ein maximaler mittlerer Materialabtrag von 70 μm bevorzugt ist. Ein besonders zweckmäßiger mittlerer Materialabtrag beträgt bei nicht weiter behandelten, sägerauhen Oberflächen maximal 50 bzw. 40 μm.

Wird ein mittels groben Korn vorbehandelter Siliziumblock geätzt, so haben sich hier minimale mittlere Ätztiefen von mindestens 5 μm, insbesonders mindestens 7, vorzugsweise mindestens 8 μm als zweckmäßig erwiesen. Besonders bevorzugt sind mittlere Mindestätztiefen von 10 μm, wobei die maximale mittlere Ätztiefe in grob vorgeschliffenen Materialien üblicherweise 50 μm beträgt, wobei maximal 40, insbesonders maximal 30 bevorzugt sind. Ganz besonders bevorzugt sind in solchen Fällen Ätztiefen bis maximal 25 μm.

Wird ein sowohl grob vor- als auch danach fein geschliffener bzw. polierter Siliziumblock geätzt, so haben sich hier minimale mittlere Ätztiefen von mindestens 3, insbesonders mindestens 4 μm als sinnvoll erwiesen, wobei mindestens 5, insbesonders mindestens 7 sich als besonders zweckmäßig erwiesen haben. Ganz besonders sind Mindestätztiefen von 8 μm bevorzugt. Bei derart vorbehandelten Siliziumblöcken hat sich ein maximaler Ätzabtrag bis zu 30 μm als sinnvoll erwiesen, wobei maximal 25 μm, insbesonders maximal 20 μm bevorzugt ist. Ganz besonders bevorzugt sind maximale Abtragstiefen bis zu 18, insbesonders bis zu 16 μm.

Es hat sich jedoch auch gezeigt, dass aus ökonomischen Gründen eine Optimierung von der Ätzdauer bei entsprechender Ätztemperatur sowie Ätzabtrag bei zweckmäßigerweise mindestens 30s, insbesonders mindestens 45 Sekunden liegt, wobei eine Untergrenze von 60 Sekunden sich als besonders zweckmäßig erwiesen hat. Maximale Ätzdauern betragen üblicherweise 300 Sekunden, wobei 250s, insbesonders 200 bzw. 150 Sekunden ganz besonders bevorzugt sind.

Wenn Siliziumwafer, die nach einem der vorstehend genannten Verfahren hergestellt werden, zur Darstellung von Solarzellen verwendet werden, ist die Ausbeute der Solarzellen erhöht, da die Bruchrate der Siliziumwafer deutlich geringer ist. Vorzugsweise weisen die erfindungsgemäß erhaltenen Scheiben eine Dicke von kleiner gleich 180 $\mu$m auf, wobei Dicken von kleiner 170 $\mu$m, insbesonders kleiner gleich 150 bzw. kleiner gleich 120 $\mu$m besonders bevorzugt sind.

Zweckmäßigerweise wird der Siliziumblock bzw. -brick mit einer Drahtsäge in Siliziumwafer geschnitten, wie dies beispielsweise in der EP 1 674 558 A1 beschrieben ist.

Siliziumwafer, die nach einem der vorstehend genannten Verfahren hergestellt wurden, lassen sich durch herkömmliche, aus dem Stand der Technik bekannte Verfahren bei der Produktion von Solarzellen bzw. Solarmodulen einsetzen.

Ein weiterer Gegenstand der vorliegenden Erfindung ist ein Siliziumblock, der mittels dem erfindungsgemäßen Verfahren hergestellt wurde, d. h. bei dem wenigstens in einem Schritt die Seitenflächen eines Siliziumblocks im Wesentlichen parallel zur späteren Schnittebene bzw. seiner Querschnittsfläche, d. h. parallel zur späteren Waferkante geschliffen wurden.

Vorzugsweise weisen die Seitenflächen dieses geschliffenen Siliziumblocks eine Oberflächenrauhigkeit $R_{max}$ von höchstens 8 $\mu$m, insbesonders höchstens 6 $\mu$m auf. Typische Minimalwerte (Untergrenzen) betragen 0,25 $\mu$m, insbesonders 0,35 $\mu$m, wobei 0,5 bzw. 1 $\mu$m meist ausreichen. Erfolgt lediglich ein Grobschleifen beträgt die Oberflächenrauhigkeit vorzugsweise $R_{max}$ 3 $\mu$m bis 6 bzw. 8 $\mu$m. Die Oberflächenrauhigkeit bezeichnet dabei die Unebenheit der Oberflächenhöhe. Die Oberflächenrauhigkeit ist dabei höher, als die nach ISO 10110-8 definierte Oberflächenrauhigkeit für polierte Flächen.

Vorzugsweise weist dieser geschliffene Siliziumblock im Wesentlichen keine Mikrorisse mehr auf, wenn der geschliffene Siliziumbrick im duktilen Bereich bearbeitet wurde. Je nachdem ob der geschliffene Siliziumblock fein geschliffen oder grob geschliffen wurde, treten Mikrorisse auf, die im Falle multikristalliner Bricks, insbesonders bei feingeschliffenen Bricks, wegen der Nichtverfügbarkeit von Analysemethoden nicht quantifiziert werden können. Mittels Mikroskopaufnahmen ist die Oberflächenqualität jedoch sehr gut beurteilbar. Je ungestörter die Bearbeitungsspuren sind, je geringer ist die Bruchempfindlichkeit der aus derart hergestellten Bricks hergestellten Wafer.

Ein weiterer Gegenstand der vorliegenden Erfindung ist ein Siliziumwafer, der durch Zerteilen eines Siliziumblocks erhalten wurde, dessen Seitenflächen im Wesentlichen parallel zur späteren Waferkante geschliffen wurden und bei dem vorzugsweise in einem weiteren Schritt die Seitenflächen des Siliziumblocks isotrop geätzt wurden. Ein solcher Wafer weist meist keine Mikrorisse im Sinne der vorherigen Definition mehr auf.

**Patentansprüche**

1. Verfahren zur Herstellung von Siliziumwafern, die eine vorder- und rückseitige Oberfläche sowie Seitenkanten aufweisen durch Zerteilen eines insbesonders rechteckigen, Seitenflächen aufweisenden Siliziumblockes, **dadurch gekennzeichnet, dass** vor dem Zerteilen die Seitenflächen des Siliziumblocks parallel zur Kante der Siliziumwafer geschliffen und/oder poliert werden.

2. Verfahren gemäß Anspruch 1, **dadurch gekennzeichnet, dass** das Schleifen und/oder Polieren mittels eines rotierenden, hohlzylinderförmigen Schleif- bzw. Polierwerkzeuges erfolgt.

3. Verfahren gemäß Anspruch 2, **dadurch gekennzeichnet, dass** das hohlzylinderförmige Schleif- oder Polierwerkzeug einen Durchmesser von wenigstens dem 1.5-fachen, bevorzugt von wenigstens dem 1.55-fachen, besonders bevorzugt von wenigstens dem 1.75-fachen, der Breite des Siliziumblocks aufweist.

4. Verfahren nach einem der vorhergehenden Ansprüche, **dadurch gekennzeichnet, dass** die Zylinderwände des Werkzeuges gebundene Schleifkörner aufweisen.

5. Verfahren nach einem der vorhergehenden Ansprüche, **dadurch gekennzeichnet, dass** die Schleifkörner Diamant, Siliziumcarbid und/oder Siliziumnitrid umfassen.

6. Verfahren nach einem der vorhergehenden Ansprüche, **dadurch gekennzeichnet, dass** das Schleifwerkzeug eine Matrix umfasst, die ausgewählt ist aus der Gruppe bestehend aus einem weichen Metall, einem Polymer und/oder ein Harz.

7. Verfahren gemäß einem der vorhergehenden Ansprüche, **dadurch gekennzeichnet, dass** die Schleifkörner im Mittel einen Durchmesser von 3 bis 160 $\mu$m aufweisen.

8. Verfahren nach einem der vorhergehenden Ansprüche, **dadurch gekennzeichnet, dass** die Seitenflächen des Siliziumblocks zuerst mit groben Schneidkörnern geschliffen werden, die einen mittleren Durchmesser von 80 bis 160 $\mu$m aufweisen und danach mit einem Schleifwerkzeug geschliffen oder poliert werden, der Schneidkörner mit einem mittleren Durchmesser von 3 bis 40 $\mu$m aufweist.

9. Verfahren nach einem der vorhergehenden Ansprüche, **dadurch gekennzeichnet, dass** die Wafer aus dem behandelten Siliziumblock mittels einer Drahtsäge geschnitten werden.

10. Verfahren nach einem der vorhergehenden Ansprüche, **dadurch gekennzeichnet, dass** die Rotationsachse des hohlzylindrischen Werkzeuges gegenüber der senkrechten Normale der zu behandelnden Oberfläche um einen Winkel von 0,005 bis 0,05 Winkelgrad gekippt ist.

11. Verfahren nach einem der vorhergehenden Ansprüche, **dadurch gekennzeichnet, dass** der Siliziumblock nach dem Schleifen und vor dem Zersägen zu Wafern isotrop geätzt wird.

12. Siliziumblock erhältlich nach einem der Ansprüche 1 bis 11.

13. Wafer erhältlich nach einem der Ansprüche 1 bis 11.

## Claims

1. Method for producing silicon wafers having a front surface and a back surface and also lateral edges, by separating a silicon block that is rectangular, in particular, and has lateral surfaces, **characterized in that**, before the separation, the lateral surfaces of the silicon block are ground and/or polished parallel to the edge of the silicon wafers.

2. Method according to Claim 1, **characterized in that** the grinding and/or polishing is effected by means of a rotating, hollow-cylindrical grinding and/or polishing tool.

3. Method according to Claim 2, **characterized in that** the hollow-cylindrical grinding or polishing tool has a diameter of at least 1.5 times, preferably of at least 1.55 times, particularly preferably of at least 1.75 times, the width of the silicon block.

4. Method according to any of the preceding claims, **characterized in that** the cylinder walls of the tool have bonded abrasive grains.

5. Method according to any of the preceding claims, **characterized in that** the abrasive grains comprise diamond, silicon carbide and/or silicon nitride.

6. Method according to any of the preceding claims, **characterized in that** the grinding tool comprises a matrix selected from the group consisting of a soft metal, a polymer and/or a resin.

7. Method according to any of the preceding claims, **characterized in that** the abrasive grains have on average a diameter of 3 to 160 $\mu$m.

8. Method according to any of the preceding claims, **characterized in that** the lateral surfaces of the silicon block are firstly ground with coarse abrasive grains having an average diameter of 80 to 160 $\mu$m, and are then ground or polished by means of a grinding tool having abrasive grains having an average diameter of 3 to 40 $\mu$m.

9. Method according to any of the preceding claims, **characterized in that** the wafers are cut from the treated silicon block by means of a wire saw.

10. Method according to any of the preceding claims, **characterized in that** the rotation axis of the hollow-cylindrical tool is tilted relative to the perpendicular normal to the surface to be treated by an angle of 0.005 to 0.05 angular degrees.

11. Method according to any of the preceding claims, **characterized in that** the silicon block is etched isotropically after the grinding process and before the sawing process to form wafers.

12. Silicon block obtainable in a manner according to any of Claims 1 to 11.

13. Wafer obtainable in a manner according to any of Claims 1 to 11.

## Revendications

1. Procédé de fabrication de galettes en silicium, lesquelles présentent une surface côté avant et une surface côté arrière ainsi que des bords latéraux, par division d'un bloc en silicium qui présente des surfaces latérales essentiellement rectangulaires, **caractérisé en ce que** les surfaces latérales du bloc en silicium sont poncées et/ou polies parallèlement au bord de la galette en silicium avant la division.

2. Procédé selon la revendication 1, **caractérisé en ce que** le ponçage et/ou le polissage est réalisé au moyen d'un outil de ponçage ou de polissage rotatif de forme cylindrique creuse.

3. Procédé selon la revendication 2, **caractérisé en ce que** l'outil de ponçage ou de polissage rotatif de forme cylindrique creuse présente un diamètre égal à au moins 1,5 fois, de préférence au moins 1,55 fois, particulièrement de préférence au moins 1,75 fois la largeur du bloc en silicium.

4. Procédé selon l'une des revendications précédentes, **caractérisé en ce que** les parois cylindriques de l'outil présentent des grains abrasifs liés.

**5.** Procédé selon l'une des revendications précédentes, **caractérisé en ce que** les grains abrasifs comprennent du diamant, du carbure de silicium et/ou du nitrure de silicium.

**6.** Procédé selon l'une des revendications précédentes, **caractérisé en ce que** l'outil de ponçage comprend une matrice qui est choisie dans le groupe constitué d'un métal tendre, d'un polymère et/ou d'une résine.

**7.** Procédé selon l'une des revendications précédentes, **caractérisé en ce que** les grains abrasifs présentent un diamètre moyen de 3 à 160 $\mu$m.

**8.** Procédé selon l'une des revendications précédentes, **caractérisé en ce que** les surfaces latérales du bloc en silicium sont tout d'abord poncées avec des grains abrasifs grossiers, lesquels présentent un diamètre moyen de 80 à 160 $\mu$m, et sont ensuite poncées ou polies avec un outil de ponçage qui présente des grains abrasifs ayant un diamètre moyen de 3 à 40 $\mu$m.

**9.** Procédé selon l'une des revendications précédentes, **caractérisé en ce que** les galettes sont découpées dans le bloc en silicium traité au moyen d'une scie à fil.

**10.** Procédé selon l'une des revendications précédentes, **caractérisé en ce que** l'axe de rotation de l'outil cylindrique creux est incliné d'un angle de 0,005 à 0,05 degrés par rapport à la normale perpendiculaire à la surface à traiter.

**11.** Procédé selon l'une des revendications précédentes, **caractérisé en ce que** le bloc en silicium est soumis à une gravure isotrope après le ponçage et avant la découpe en galettes.

**12.** Bloc en silicium pouvant être obtenu selon l'une des revendications 1 à 11.

**13.** Galette pouvant être obtenue selon l'une des revendications 1 à 11.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2002036182 A
- US 2002036182 AA
- JP 3648239 B
- US 5484326 A
- DE 102007040390 A
- EP 1674558 A1